(19) Europäisches Patentamt / European Patent Office / Office européen des brevets

(11) **EP 3 933 422 B1**

(12) **EUROPEAN PATENT SPECIFICATION**

(45) Date of publication and mention
of the grant of the patent:
**01.11.2023   Bulletin 2023/44**

(21) Application number: **20891420.0**

(22) Date of filing: **09.05.2020**

(51) International Patent Classification (IPC):
**G01R 31/392** *(2019.01)*      **G01R 31/396** *(2019.01)*
**G01R 31/367** *(2019.01)*

(52) Cooperative Patent Classification (CPC):
**G01R 31/392; G01R 31/396;** G01R 31/367

(86) International application number:
**PCT/CN2020/089321**

(87) International publication number:
**WO 2021/217698 (04.11.2021 Gazette 2021/44)**

(54) **DIAGNOSIS METHOD FOR DISTINGUISHING MICRO-SHORT-CIRCUIT FAULT OF BATTERY FROM SMALL-CAPACITY FAULT OF BATTERY**

DIAGNOSEVERFAHREN ZUR UNTERSCHEIDUNG ZWISCHEN EINEM MIKROKURZSCHLUSSFEHLER EINER BATTERIE UND EINEM NIEDRIGKAPAZITÄTSFEHLER EINER BATTERIE

PROCÉDÉ DE DIAGNOSTIC VISANT À DISTINGUER UNE DÉFAILLANCE DE TYPE MICRO COURT-CIRCUIT DE BATTERIE D'UNE DÉFAILLANCE DE TYPE FAIBLE CAPACITÉ DE BATTERIE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.04.2020   CN 202010358554**

(43) Date of publication of application:
**05.01.2022   Bulletin 2022/01**

(73) Proprietor: **University of Shanghai for Science and Technology**
**Shanghai 200093 (CN)**

(72) Inventors:
• **ZHENG, Yuejiu**
  **Shanghai 200093 (CN)**
• **LUO, Qi**
  **Shanghai 200093 (CN)**
• **ZHOU, Long**
  **Shanghai 200093 (CN)**

(74) Representative: **Sach, Greg Robert**
**Sach & Associates**
**Siedlungsstrasse 4a**
**85253 Erdweg (DE)**

(56) References cited:
CN-A- 101 706 556      CN-A- 106 802 396
CN-A- 108 196 190      CN-A- 108 196 190
CN-A- 108 333 526      CN-A- 109 239 613
JP-A- 2015 032 517

• ZHENG YUEJIU ET AL: "Micro-Short-Circuit Cell Fault Identification Method for Lithium-Ion Battery Packs Based on Mutual Information", IEEE TRANSACTIONS ON INDUSTRIAL ELECTRONICS, IEEE SERVICE CENTER, PISCATAWAY, NJ, USA, vol. 68, no. 5, 9 April 2020 (2020-04-09), pages 4373-4381, XP011836688, ISSN: 0278-0046, DOI: 10.1109/TIE.2020.2984441 [retrieved on 2021-02-08]
• GAO WENKAI ET AL: "Micro-Short-Circuit Diagnosis for Series-Connected Lithium-Ion Battery Packs Using Mean-Difference Model", IEEE TRANSACTIONS ON INDUSTRIAL ELECTRONICS, IEEE SERVICE CENTER, PISCATAWAY, NJ, USA, vol. 66, no. 3, 1 March 2019 (2019-03-01), pages 2132-2142, XP011693797, ISSN: 0278-0046, DOI: 10.1109/TIE.2018.2838109 [retrieved on 2018-10-31]

**Description**

**Technical Field**

The present invention relates to the technical field of lithium battery management, and particularly to a diagnosis method for distinguishing micro short circuit and small capacity faults of a battery.

**Background**

In recent years, with the policy support of the state and government for new energy vehicles and the continuous maturity of new energy vehicle technology, electric vehicles have been widely used. However, during the long-term use of the electric vehicles, battery faults may occur due to aging or other reasons, which requires *BMS* to find the faults in time and to make rapid diagnosis. Common faults mainly include internal short circuit, capacity difference, etc., which may cause abnormal changes of *SOC*. Therefore, the faults can be diagnosed according to these abnormal changes. However, in some existing studies, researchers usually ignore the existence of short circuit for capacity estimation and the existence of capacity difference for short circuit fault diagnosis.

In the process of single discharge, both small-capacity cells and short-circuit cells have abnormal features that the *SOC* difference may increase continuously, that is to say, if the fault diagnosis is performed only according to the inconsistent change trend of the battery cells in the process of single discharge, it is possible to mistakenly diagnose the small-capacity cell as the short-circuit cell or misjudge the short-circuit cell as the small-capacity cell; and in the process of single charge, it is possible to misjudge the short-circuit cell as the large-capacity cell.

During the use in real vehicles, especially with the attenuation of battery life, the capacity inconsistence among the cells in the battery pack may increase, and the risk of short circuit may increase. Therefore, when the fault diagnosis is performed, it is necessary to consider the difference between the short circuit and the capacity, so that the correct judgment can be made.

Zheng Yuejiu et al. " Micro-Short-Circuit Cell Fault Identification Method for Lithium-Ion Battery Packs Based on Mutual Information" describes that during the usage of electric vehicles, the battery decays and the cell variations expand in the battery pack. In the discharge process, both the low-capacity cell and the micro-short-circuit (MSC) cell have the abnormal feature that the state-of-charge (SOC) differences increase continuously. Hence, a low-capacity cell is likely to be misdiagnosed as an MSC cell, and vice versa. In this article, a fault identification approach based on mutual information is proposed to detect the MSC cell and low-capacity cell. A decision tree for fault identification is established by analyzing the battery fault characteristics of the short circuit, low capacity, and the abnormality of initial SOC difference. It is pointed out that the SOC deviation of the low-capacity cell is related to the mean SOC, while that of the MSC cell is related to time. A low-pass filter is used to get internal resistance differences in order to achieve the SOC deviations based on the cell different model. Finally, the MSC cell and the low-capacity cell can be identified using the mutual information which can quantitatively calculate the correlation between the SOC deviation and the mean SOC. Experimental results prove that the proposed method is reliable to identify the MSC cell and the low-capacity cell.

Gao Wenkai et al. "Micro-Short-Circuit Diagnosis for Series-Connected Lithium-Ion Battery Packs Using Mean-Difference Model" describes that micro-short-circuit (MSC) is a latent risk in power batteries, which may give rise to thermal runaway and even catastrophic safety hazards. The motivation of this paper is to quantitatively analyze MSC in an initial stage, particularly for lithium-ion batteries. To verify the feasibility of the proposed method, an equivalent MSC experiment is carried out. Based on a cell difference model, the cell state of charge (SOC) differences with the mean SOC for a battery pack are estimated by extended Kalman filter. The evaluated SOC difference can track the actual value well. Furthermore, an MSC diagnostic method is developed by employing recursive least squares filter. The method is demonstrated to examine the short-circuit resistance accurately. The results also show that the proposed method requires low computational load for the SOC difference and short-circuit resistance diagnosis.

**Summary of the Invention**

A purpose of the present invention is to provide a diagnosis method which is accurate in diagnosis results and capable of effectively distinguishing micro short circuit and small capacity

To achieve the above purpose, the present invention provides a diagnosis method for distinguishing micro short circuit and small capacity faults of a battery, as defined in claim 1.

Preferably, in the step S 1, a mean difference model is adopted to estimate the mean state of charge $SOC_{mean}$ of the battery pack and the difference *(dSOC)* between the state of charge of each cell and the mean state of charge of the battery pack by utilizing an EKF algorithm.

Preferably, the selected mean battery model is a second-order *RC* model, which estimates the mean state of charge $SOC_{mean}$ in a high-frequency way; and the selected difference battery model is a *Rint* model, which estimates the difference *(dSOC)* between the state of charge of the cell and the mean state of charge of the battery pack in a low-frequency way.

Preferably, in the step S2, the transferred charge quantity $\Delta Q_i$ at every moment represents the charge quantity of the cell *i* transferred from the moment $t_0$ to the moment $t_j$, and is calculated by adopting an ampere-hour integration method through a formula as follows:

$$\Delta Q_i = \int_{t_0}^{t_j} I(t)\,dt$$

The variable quantity $\Delta SOC_i$ of the *SOC* represents the variable quantity of the *SOC* of the cell *i* from the moment $t_0$ to the moment $t_j$, and the formula is as follows:

$$\Delta SOC_i = SOC_i(t_j) - SOC_i(t_0)$$

In the formula, $t_0$ is a start moment of each charge or discharge; and the maximum of $t_j$ is an end moment of each charge or discharge, and thus can obtain all $\Delta Q_i$ and $\Delta SOC_i$ in a whole interval of each charge and discharge.

Preferably, in the step S2, in the capacity estimation method, a capacity calculation formula of the cell *i* is as follows:

$$C_i = \frac{\int_{t_0}^{t_j} I(t)\,dt}{\Delta SOC_i}$$

$$\Delta Q_i(t_j) = C_i \Delta SOC_i + b$$

C; represents the capacity of the cell *i,* which is unknown. However, by defining $(\Delta SOC_i, \Delta Q_i)$ as feature points, a linear relationship between $\Delta Q_i$ and $SOC_i$ can be reflected according to a scatter plot formed by a plurality of feature points, and the capacity $C_i$ of cell *i* can be obtained according to a linear regression method.

Compared with the prior art, the present invention has the following advantages:

(1) The diagnosis method for distinguishing micro short circuit and small capacity faults of the battery provided by the present invention can rapidly calculate the capacity of the cell so as to perform the fault diagnosis, thereby having small calculation quantity and high diagnosis speed.

(2) The capacity estimated value can well follow the reference value, which can accurately distinguish the micro-short-circuit cell and the small-capacity cell, so that the diagnosis result is accurate.

**Brief Description of the Drawings**

FIG. 1 is a flow diagram of a diagnosis method for distinguishing micro short circuit and small capacity faults of a battery according to the present invention.

FIG. 2 is a diagram of a mean battery model and a difference battery model adopted in an embodiment of the diagnosis method for distinguishing the micro short circuit and small capacity faults of the battery according to the present invention.

FIG. 3 is a result comparison diagram of a capacity estimated value and a reference value by utilizing a least square method to estimate the capacity.

**Detailed Description of the Preferred Embodiments**

To make the purpose, technical solutions and advantages of the present invention clearer, the technical solutions of the present invention are described in detail below.

The present embodiment selects 4 battery cells with inconsistent capacity as experimental subjects which are serially connected. A No. 2 cell is connected with an external resistor with resistance of 13Q to simulate the short circuit.

For experimental conditions, a dynamic stress test condition is selected as the discharge condition, and a 1/3C constant-current and constant-voltage charge mode is selected as the charge condition, and three charge and discharge cycles are carried out.

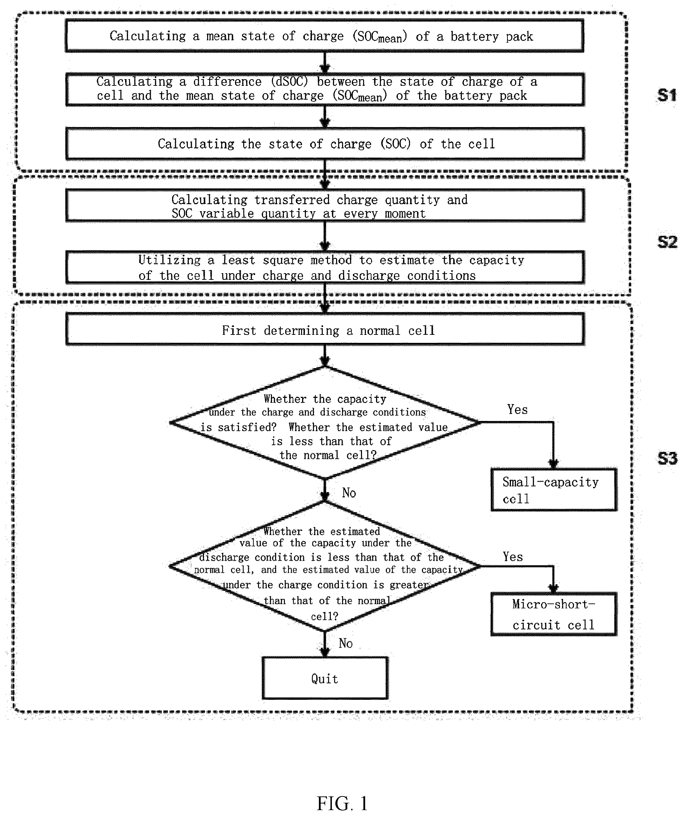

A flow diagram for distinguishing micro short circuit and small capacity faults of the battery of the present invention is as shown in Fig. 1, which specifically includes the following steps:

S1, a mean difference model is adopted to estimate a mean state of charge $SOC_{mean}$ of a battery pack and a difference (dSOC) between the state of charge of each cell and the mean state of charge of the battery pack, and then SOC of each cell is obtained:

The step S1 specifically includes the following steps:

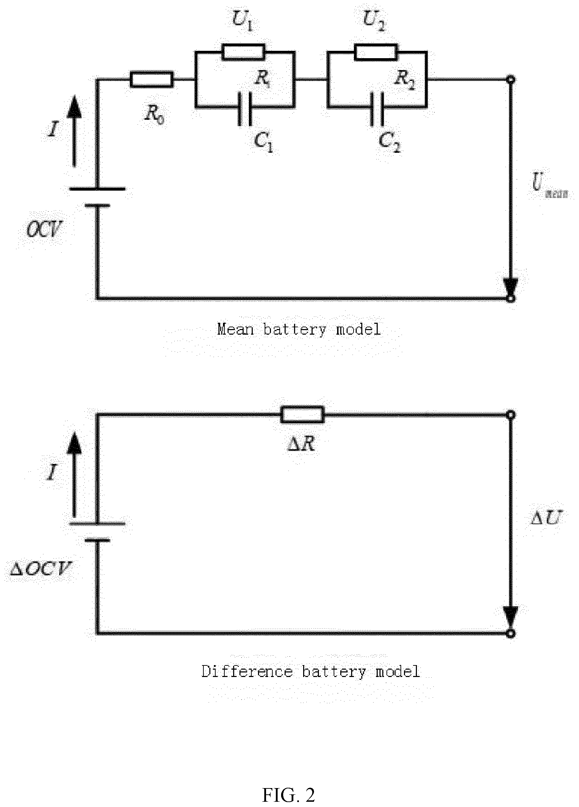

1) A sensor is used to acquire a current value $I$ of the battery pack and a voltage value $U_i$ of each cell;
2) A second-order RC model as shown in FIG. 2 is selected as a mean battery model, a mean voltage value $U_{mean}$ of all cells is obtained, $I$ and $U_{mean}$ are taken as input values to estimate the mean state of charge $SOC_{mean}$ of the battery pack through the EKF algorithm;

The voltage $U_{mean}$ at the output end of the second-order RC model is:

$$U_{mean} = OCV(SOC_{mean}) - IR_0 - U_1 - U_2 \tag{1}$$

Polarization voltages $U_1$ and $U_2$ are respectively:

$$U_1 = IR_1[1 - exp(-t/\tau_1)] \tag{2}$$

$$U_2 = IR_2[1 - exp(-t/\tau_2)] \tag{3}$$

OCV represents an open-circuit voltage of the mean battery, $SOC_{mean}$ represents a state of charge of the mean battery, and OCV and $SOC_{mean}$ have a one-to-one correspondence in a balanced state; $I$ represents current passing through the mean battery; $R_0$ represents ohmic internal resistance of the mean battery; $U_1$ and $U_2$ respectively represent a first polarization voltage and a second polarization voltage; and $\tau_1$ and $\tau_2$ respectively represent first polarization internal resistance and second polarization internal resistance of the mean battery.
State equations:

$$SOC_{mean,\,k+1} = SOC_{mean,\,k} + \frac{\eta \times \Delta t}{3600 \times C} \times I_k + w_k \tag{4}$$

$$U_{1,k+1} = U_{1,k}exp(-\Delta t/\tau_{1,k}) + I_k R_{1,k}[1 - exp(-\Delta t/\tau_{1,k})] \tag{5}$$

$$U_{2,k+1} = U_{2,k}exp(-\Delta t/\tau_{2,k}) + I_k R_{2,k}[1 - exp(-\Delta t/\tau_{2,k})] \tag{6}$$

Output equation:

$$U_{mean,k} = OCV(SOC_{mean,k}) - I_k R_0 - U_{1,k} - U_{2,k} + v_k \tag{7}$$

In the equations, $SOC_{mean}$, $k$ is the mean state of charge of the battery pack at node moment $k$; $\Delta t$ is the sampling time; $I_k$ is the current value measured by the current sensor at the node moment $k$; $U_{1,k}$ and $U_{2,k}$ are voltages of the first polarization internal resistance and the second polarization internal resistance of the mean battery at the node moment $k$; $OCV(SOC_{mean}, k)$ is the open-circuit voltage of the battery pack at the node moment $k$; $w_k$ and $v_k$ respectively represent input measurement noise and output measurement noise, respectively, $w_k$ corresponds to the ampere-hour integration method, and the smaller the variance of $w_k$, the more trusted in the estimated value of ampere-hour integration method; and $v_k$ corresponds to a voltage correction link of the battery model, and the smaller the variance of $v_k$, the more trusted in the estimated value after the voltage correction of the battery model. The variances of $w_k$ and $v_k$ are respectively 1e-12 and 0.01; and $\eta$ is coulombic efficiency and is 1 here.

Equations (4), (5) and (6) constitute the state equation:

$$f(x_k, u_k) = \begin{bmatrix} 1 & 0 & 0 \\ 0 & \exp(-\Delta t/\tau_1) & 0 \\ 0 & 0 & \exp(-\Delta t/\tau_2) \end{bmatrix} \times \begin{bmatrix} SOC_{mean,k} \\ U_{1,k} \\ U_{2,k} \end{bmatrix}$$
$$+ \begin{bmatrix} -\eta\Delta t/C_n \\ R_1(1-\exp(-\Delta t/\tau_1)) \\ R_2(1-\exp(-\Delta t/\tau_2)) \end{bmatrix} \times I_k \qquad (8)$$

Equation (7) constitutes the output equation:

$$g(x_k, u_k) = OCV(SOC_{mean,k}) - I_k R_0 - U_{1,k} - U_{2,k} \qquad (9)$$

In the equations, $f(x_k, u_k)$ is a state function of the mean battery; $g(x_k, u_k)$ is a measurement function of the mean battery, i.e. a terminal voltage value of the mean battery estimated by the mean battery model.

State vector:

$$x_k = \begin{bmatrix} SOC_{mean, k}, U_{1,k}, U_{2,k} \end{bmatrix} \qquad (10)$$

Coefficient matrixes:

$$A_k = \left.\frac{\partial f(x_k, u_k)}{\partial x_k}\right|_{x_k = \hat{x}_k^+} = \begin{bmatrix} 1 & 0 & 0 \\ 0 & \exp(-\Delta t/\tau_1) & 0 \\ 0 & 0 & \exp(-\Delta t/\tau_2) \end{bmatrix} \qquad (11)$$

$$C_k = \left.\frac{\partial g(x_k, u_k)}{\partial x_k}\right|_{x_k = \hat{x}_k^-} = \begin{bmatrix} \left.\frac{dOCV(SOC)}{dSOC}\right|_{SOC_k = \widehat{soc}_k^-} & -1 & -1 \end{bmatrix} \qquad (12)$$

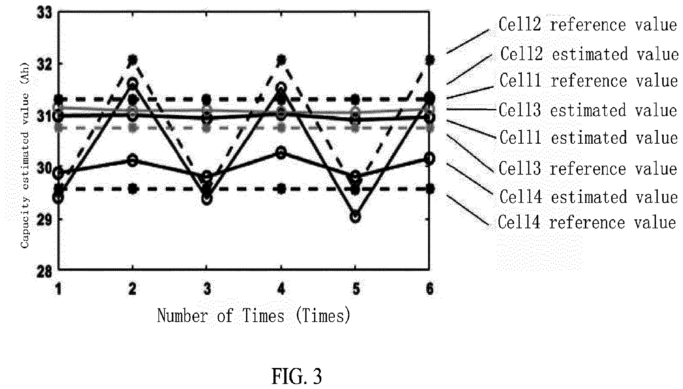

3) The *Rint* model as shown in FIG. 3 is used as a difference battery model, the current value *I* of the battery pack measured by the current sensor and the difference $\Delta U$, measured by the voltage sensor, between the voltage value *U* of the cell and the mean voltage value $U_{mean}$ are used as input values, and the state of charge difference (*dSOC*) between the cell and the mean battery is estimated through the *EKF* algorithm;

The voltage at the output end of the *Rint* model:

$$\Delta U = \Delta OCV(\Delta SOC) - I\Delta R \qquad (13)$$

The state equation and the output equation are:

$$f\left(x_k^i\right) = \Delta SOC_k^i \quad (14)$$

$f\left(x_k^i\right)$ is a state function of the difference battery, and $g\left(x_k^i\right)$ is a measurement function of the difference battery, i.e. the voltage at the difference battery end estimated by the difference battery model; $\Delta OCV_k^i(\Delta SOC_k^i)$ represents the difference between the open-circuit voltage of the ith cell nearby the mean state of charge $SOC_{mean}$ in the balanced state and the mean open-circuit voltage of the battery pack; $\Delta R_i$ represents the difference between the internal resistance of the ith cell and the mean internal resistance of the battery pack; and $I_k$ is the current value measured by the current sensor at the node moment $k$.

State vector:

$$x_k^i = \Delta SOC_k^i \quad (16)$$

Coefficient matrixes:

$$A_k^i = \left.\frac{\partial f}{\partial x}\right|_{x_k = \hat{x}_k^{i,+}} = 1 \quad (17)$$

$$C_k^i = \left.\frac{\partial g}{\partial x}\right|_{x_k = \hat{x}_k^{i,-}} = \left.\frac{dOCV^i(\Delta SOC)}{d\Delta SOC}\right|_{\Delta SOC = \widehat{\Delta SOC}_k^{i,+}} \quad (18)$$

4) The *SOC* of each battery cell is obtained according to the state of charge $SOC_{mean}$ of the mean battery and the state of charge difference *(dSOC)* between the cell and the mean battery.

S2, transferred charge quantity and SOC variable quantity of each cell at every moment under charge and discharge conditions are calculated respectively, and then the least square method is utilized to estimate the capacity of each battery cell under the charge and the discharge conditions.

The step S2 specifically includes the following steps:

1) The transferred charge quantity $\Delta Q_i$ of each cell at every moment, which represents the charge quantity of the cell *i* transferred from the moment $t_0$ to the moment $t_j$, is calculated by adopting an ampere-hour integration method through a formula as follows:

$$\Delta Q_i = \int_{t_0}^{t_j} I(t)dt \quad (19)$$

The variable quantity $\Delta SOC_i$ of the *SOC* represents the variable quantity of the *SOC* of the cell *i* from the moment $t_0$ to the moment $t_j$, and the formula is as follows:

$$\Delta SOC_i = SOC_i\left(t_j\right) - SOC_i\left(t_0\right)$$

(20)

The $t_0$ here is a start moment of each charge or discharge; and the maximum of $t_j$ is an end moment of each charge or discharge. Thus, all $\Delta Q_i$ and $\Delta SOC_i$ in a whole interval of each charge and discharge can be obtained.

2) The least square method is utilized to estimate the capacity of each battery cell under the charge and the discharge conditions.

According to the feature points ($\Delta SOC_i$ and $\Delta Q_i$) obtained in 1), the least square method is utilized to obtain the capacity estimated value of each battery cell under the charge and the discharge conditions.

S3, the estimated results of each charge and discharge capacity of the battery cell are compared;

1) The battery cells with similar capacity and similar estimated value of the charge and discharge capacity are normal cells; The normal battery cell refers to that the result of the capacity of the cell estimated at a certain time is consistent with that of a majority of cells, that is, a median deviation from the cell capacity is within $p1\%$, and the difference between the charge capacity and the discharge capacity is within $p1\%$;

2) If the estimated value of the cell under both charge and discharge conditions is all less than that of the normal cell by more than $p2\%$, and the difference between the charge capacity and the discharge capacity is within $p1\%$, then the cell is determined as a small-capacity cell;

3) If the estimated value under the discharge condition is less than that of the normal cell, while the estimated value under the charge condition is greater than that of the normal cell, and the charge capacity is greater than the discharge capacity by $p3\%$, then the cell is determined as the micro-short-circuit cell.

Generally, $p1=2$, $p2=3$, and $p3=5$.

It can be seen from the capacity estimation diagram obtained through the embodiment as shown in FIG. 3 that the cells 1 and 3 are normal cells. The capacity estimated value of the cell 2 is less than that of the normal cell when in discharge and greater than that of the normal cell when in charge. Therefore, the cell 2 can be determined as the micro-short-circuit cell. The capacity estimated value of the cell 4 under both the charge and discharge conditions is respectively less than that of the normal cell. Therefore, the cell 4 can be determined as the small-capacity cell. Therefore, it can be seen that the diagnosis method for distinguishing the two faults, i.e. the short circuit and the small capacity in the battery adopted by the present invention can rapidly and accurately distinguish the short-circuit fault and the small-capacity fault.

The above descriptions are only preferred embodiments of the present invention rather than limitation to the present invention, which is defined by the appended claims.

**Claims**

1. A diagnosis method for distinguishing micro short circuit and small capacity faults of a battery, **characterized by** comprising the following steps:

   S1, predicting a mean state of charge $SOC_{mean}$ of a battery pack and a difference *(dSOC)* between the state of charge of each cell and the mean state of charge of the battery pack, and then obtaining $SOC$ of each cell;
   S2, calculating transferred charge quantity and $SOC$ variable quantity of each cell at every moment under charge and discharge conditions, and then utilizing a least square method to estimate the capacity of each battery cell under the charge and discharge conditions; and
   S3, comparing estimated results of each charge and discharge capacity of the battery cell, wherein the battery cells with similar capacity and similar charge and discharge capacity are normal cells;
   the cell with the estimated value under the discharge condition less than that of the normal cell and the estimated value under the charge condition greater than that of the normal cell is a micro-short-circuit cell;
   the cell with the estimated value less than that of the normal cell under both the charge and discharge conditions is the small-capacity cell,
   wherein in the step S3, the normal battery cell with similar capacity and similar charge and discharge capacity refers to that the result of the capacity of the cell estimated at a certain time is consistent with that of a majority of cells, that is, a median deviation from the cell capacity is within $p1\%$, and the difference between the charge capacity and the discharge capacity is within $p1\%$; and under both the charge and discharge conditions, if the estimated value is less than that of the normal cell by more than $p2\%$, and the difference between the charge capacity and the discharge capacity is within $p1\%$, then the cell is determined as the small-capacity cell;

if the estimated value under the discharge condition is less than that of the normal cell, while the estimated value under the charge condition is greater than that of the normal cell, and the charge capacity is greater than the discharge capacity by $p3\%$, then the cell is determined as the micro-short-circuit cell, wherein $p1=2$, $p2=3$, and $p3=5$.

2. The diagnosis method for distinguishing micro short circuit and small capacity faults of the battery according to claim 1, **characterized in that** in the step S1, a mean difference model is adopted to estimate the mean state of charge $SOC_{mean}$ of the battery pack and the difference ($dSOC$) between the state of charge of each cell and the mean state of charge of the battery pack by utilizing an *EKF* algorithm.

3. The diagnosis method for distinguishing micro short circuit and small capacity faults of the battery according to claim 2, **characterized in that** the selected mean battery model is a second-order *RC* model, which estimates the mean state of charge $SOC_{mean}$ in a high-frequency way; and the selected difference battery model is a *Rint* model, which estimates the difference *(dSOC)* between the state of charge of the cell and the mean state of charge of the battery pack in a low-frequency way.

4. The diagnosis method for distinguishing micro short circuit and small capacity faults of the battery according to claim 1, **characterized in that** in the step S2, the transferred charge quantity $\Delta Q_i$ at every moment represents the charge quantity of the cell $i$ transferred from the moment $t_0$ to the moment $t_j$, and is calculated by adopting an ampere-hour integration method through a formula as follows:

$$\Delta Q_i = \int_{t_0}^{t_j} I(t)\,dt$$

the variable quantity $\Delta SOC_i$ of the $SOC$ represents the variable quantity of the $SOC$ of the cell $i$ from the moment $t_0$ to the moment $t_j$, and the formula is as follows:

$$\Delta SOC_i = SOC_i(t_j) \quad SOC_i(t_0)$$

in the formula, $t_0$ is a start moment of each charge or discharge; and the maximum of $t_j$ is an end moment of each charge or discharge, and thus can obtain all $\Delta Q_i$ and $\Delta SOC_i$ in a whole interval of each charge and discharge.

5. The diagnosis method for distinguishing micro short circuit and small capacity faults of the battery according to claim 1, **characterized in that** in the S2, in the capacity estimation method, a capacity calculation formula of the cell $i$ is as follows:

$$C_i = \frac{\int_{t_0}^{t_j} I(t)\,dt}{\Delta SOC_i}$$

$$\Delta Q_i(t_j) = C_i \Delta SOC_i + b$$

$C_i$ represents the capacity of the cell $i$, which is unknown; however, by defining ($\Delta SOC_i$, $\Delta Q_i$) as feature points, a linear relationship between $\Delta Q_i$ and $SOC_i$ can be reflected according to a scatter plot formed by a plurality of feature points, and the capacity $C_i$ of cell $i$ can be obtained according to a linear regression method.

**Patentansprüche**

1. Diagnoseverfahren zur Unterscheidung von Mikrokurzschluss und kleinen Kapazitätsfehlern einer Batterie, **dadurch gekennzeichnet, dass** es die folgenden Schritte umfasst:

S1, Vorhersagen eines mittleren Ladezustands $SOC_{mean}$ eines Batteriesatzes und einer Differenz (dSOC) zwischen dem Ladezustand jeder Zelle und dem mittleren Ladezustand des Batteriesatzes und anschließende Ermitteln des SOC jeder Zelle;

S2, Berechnen der übertragenen Ladungsmenge und der SOC-Variablenmenge jeder Zelle zu jedem Zeitpunkt unter Lade- und Entladebedingungen und anschließendes Anwenden einer Methode der kleinsten Quadrate, um die Kapazität jeder Batteriezelle unter den Lade- und Entladebedingungen zu schätzen; und

S3, Vergleichen der geschätzten Ergebnisse jeder Lade- und Entladekapazität der Batteriezelle, wobei die Batteriezellen mit ähnlicher Kapazität und ähnlicher Lade- und Entladekapazität normale Zellen sind;

wobei die Zelle, deren geschätzte Wert unter der Entladebedingung kleiner als der der normalen Zelle und der geschätzte Wert unter der Ladebedingung größer als der der normalen Zelle ist, eine Mikrokurzschlusszelle ist;

wobei die Zelle, deren geschätzter Wert sowohl unter der Ladebedingung als auch bei der Entladebedingung unter dem der normalen Zelle liegt, die Zelle mit geringer Kapazität ist,

wobei im Schritt S3 die normale Batteriezelle mit ähnlicher Kapazität und ähnlicher Lade- und Entladekapazität sich darauf bezieht, dass das Ergebnis der zu einem bestimmten Zeitpunkt geschätzten Kapazität der Zelle mit dem der Mehrheit der Zellen übereinstimmt, d.h. eine mittlere Abweichung von der Zellkapazität liegt innerhalb von $p1\%$, und die Differenz zwischen der Ladekapazität und der Entladekapazität liegt innerhalb von $p1\%$; und wobei die Zelle als Zelle mit geringer Kapazität dann bestimmt wird, wenn sowohl unter den Lade- als auch unter den Entladebedingungen der geschätzte Wert um mehr als $p2\%$ geringer als der der normalen Zelle ist und die Differenz zwischen der Ladekapazität und der Entladekapazität innerhalb von $p1\%$ liegt,

wobei die Zelle als Mikrokurzschlusszelle dann bestimmt wird, wenn der geschätzte Wert unter der Entladebedingung kleiner als der der normalen Zelle ist, während der geschätzte Wert unter der Ladebedingung größer als der der normalen Zelle ist und die Ladekapazität um $p3\%$ größer als die Entladekapazität ist,

wobei $p1=2$, $p2=3$ und $p3=5$.

2.  Diagnoseverfahren zur Unterscheidung von Mikrokurzschluss und kleinen Kapazitätsfehlern einer Batterie nach Anspruch 1, **dadurch gekennzeichnet, dass** im Schritt S1 ein mittelwertdifferenzmodell verwendet wird, um den mittleren Ladezustand $SOC_{mean}$ des Batteriesatzes und die Differenz *(dSOC)* zwischen dem Ladezustand jeder Zelle und dem mittleren Ladezustand des Batteriesatzes mithilfe eines EKF-Algorithmus zu schätzen.

3.  Diagnoseverfahren zur Unterscheidung von Mikrokurzschluss und kleinen Kapazitätsfehlern einer Batterie nach Anspruch 2, **dadurch gekennzeichnet, dass** das ausgewählte mittlere Batteriemodell ein *RC*-Modell zweiter Ordnung ist, das den mittleren Ladezustand $SOC_{mean}$ in einer hochfrequenten Weise schätzt; und dass das ausgewählte Differenz-Batteriemodell ein *Rint*-Modell ist, und dass die Differenz *(dSOC)* zwischen dem Ladezustand der Zelle und dem mittleren Ladezustand des Batteriesatzes in einer niederfrequenten Weise schätzt.

4.  Diagnoseverfahren zur Unterscheidung von Mikrokurzschluss und kleinen Kapazitätsfehlern einer Batterie nach Anspruch 1, **dadurch gekennzeichnet, dass** im Schritt S2 die übertragene Ladungsmenge $\Delta Q_i$ zu jedem Zeitpunkt die Ladungsmenge der Zelle $i$ darstellt, die vom Zeitpunkt $t_0$ bis zum Zeitpunkt $t_j$ übertragen wurde, und wobei durch Anwendung einer Amperestunden-Integrationsmethode mit Hilfe der folgenden Formel berechnet wird :

$$\Delta Q_i = \int_{t_0}^{t_j} I(t)\,dt$$

wobei die variable Größe $\Delta SOC_i$ des *SOC* die variable Größe des *SOC* der Zelle $i$ vom Zeitpunkt $t_0$ bis zum Zeitpunkt $t_j$ darstellt, und die Formel lautet wie folgt:

$$\Delta SOC_i = SOC_i(t_j) \quad SOC_i(t_0)$$

wobei in der Formel $t_0$ ein Startzeitpunkt jeder Ladung oder Entladung ist; und das Maximum von $t_j$ ein Endzeitpunkt jeder Ladung oder Entladung ist, so dass alle $\Delta Q_i$ und $\Delta SOC_i$ in einem ganzen Intervall jeder Ladung und Entladung erhalten werden können.

5.  Diagnoseverfahren zur Unterscheidung von Mikrokurzschluss und kleinen Kapazitätsfehlern einer Batterie nach Anspruch 1, **dadurch gekennzeichnet, dass** in Schritt S2 in dem Kapazitätsabschätzungsverfahren eine Kapazitätsberechnungsformel der Zelle $i$ wie folgt lautet:

$$C_i - \frac{\int_{t_0}^{t_j} I(t)dt}{\Delta SOC_i}$$

$$\Delta Q_i(t_j) = C_i \Delta SOC_i + b$$

wobei C; die Kapazität der Zelle *i* darstellt, die nicht bekannt ist; wobei durch die Definition von (($\Delta SOC_i$, $\Delta Q_i$) als Merkmalspunkte jedoch eine lineare Beziehung zwischen $\Delta Q_i$ und *SOC* gemäß einem einem durch mehrere Merkmalspunkte gebildeten Streudiagramm wiedergegeben werden kann, und wobei die Kapazität $C_i$ der Zelle *i* gemäß einer linearen Regressionsmethode erhalten werden kann.

## Revendications

1. Un procédé de diagnostic pour distinguer les défauts de micro-court-circuit et de petite capacité d'une batterie, **caractérisé en ce qu'**il s'agit des étapes suivantes :

   S1, estimer l'état de charge moyenne du bloc-batterie $SOC_{mean}$ et la différence entre l'état de charge moyenne de chaque cellule et celui du bloc-batterie (*dSOC*), pour obtenir ainsi le *SOC* de chaque cellule ;
   S2, calculer la quantité de charges déplacées et la variation du SOC de chaque cellule à tout moment respectivement dans les conditions de recharge et de décharge, ensuite, estimer la capacité de chaque cellule de batterie dans les conditions de recharge et de décharge à l'aide de la méthode des moindres carrées ;
   S3, comparer les résultats estimés de la capacité des différentes recharges et décharges des cellules de batteries, parmi lesquelles les cellules ayant une capacité similaire et les capacités de recharge et de décharge similaires sont des cellules normales;
   Toute cellule dont la valeur estimée dans la condition de décharge est inférieure à celle des cellules normales et dont la valeur estimée dans la condition de recharge est supérieure à celle des cellules normales est une cellule en micro-court-circuit;
   Toute cellule dont les valeurs estimées tant dans la condition de recharge que dans la condition de décharge sont inférieures à celles des cellules normales est une cellule de petite capacité,
   Pour les étapes ci-dessus,
   Dans la S3, une cellule de batterie normale ayant une capacité similaire et les capacités estimées de recharge et de décharge similaires signifie que le résultat d'une certaine estimation de la capacité de cette cellule est identique à celle de la plupart des cellules, c'est-à-dire que l'écart par rapport à la médiane des capacités des cellules est inférieur à *p*1% et que la différence entre la capacité de recharge et la capacité de décharge est inférieure à *p*1% ; Si une cellule dont les valeurs estimées tant dans la condition de recharge que dans la condition de décharge sont toutes moins petites de plus de *p*2% que celles des cellules normales et pour laquelle la différence entre la capacité de recharge et la capacité de décharge est inférieure à *p*1%, cette cellule est jugée comme une cellule de petite capacité;
   Toute cellule dont la valeur estimée dans la condition de décharge est inférieure à celle des cellules normales et dont la valeur estimée dans la condition de recharge est supérieure à celle des cellules normales, et dont la capacité de recharge est plus grande de p3% que la capacité de décharge sera jugée comme une cellule en micro-court-circuit,
   Où *p*1=2, *p*2=3, et *p*3=5.

2. Un procédé de diagnostic pour distinguer les défauts de micro-court-circuit et de petite capacité d'une batterie selon la revendication 1, **caractérisé en ce que** Pour les étapes ci-dessus,

   S1, des modèles moyen et différentiel sont adoptés
   pour estimer l'état de charge moyenne du bloc-batterie $SOC_{mean}$ et la différence entre l'état de charge moyenne de chaque cellule et celui du bloc-batterie (*dSOC*) à l'aide de l'algorithme EKF.

3. Un procédé de diagnostic pour distinguer les défauts de micro-court-circuit et de petite capacité d'une batterie selon la revendication 2, **caractérisé en ce que** le modèle moyen de batterie sélectionné est un modèle *RC* du second ordre, permettant d'estimer l'état de charge moyenne $SOC_{mean}$ du bloc-batterie à haute fréquence; et le modèle différentiel de batterie est un modèle Rint, permettant d'estimer la différence entre l'état de charge moyenne de chaque cellule et celui du bloc-batterie (*dSOC*) à basse fréquence.

4. Un procédé de diagnostic pour distinguer les défauts de micro-court-circuit et de petite capacité d'une batterie selon la revendication 1, **caractérisé en ce que** parmi les étapes,

S2, la quantité de charges déplacées à tout moment $\Delta Q_i$ représente la quantité de charges déplacées par la cellule *i* du moment $t_0$ au moment $t_j$, qui est calculée par la méthode intégrale ampère-heure, la formule est la suivante

$$\Delta Q_i = \int_{t_0}^{t_j} I(t)dt$$

La variation $\Delta SOC_i$ du *SOC* représente la variation du SOC de la cellule *i* du moment $t_0$ au moment $t_j$, la formule est la suivante

$$\Delta SOC_i = SOC_i(t_j) - SOC_i(t_0)$$

Où $t_0$ correspond à l'instant de début de chaque recharge ou décharge, le maximum du $t_j$ correspond à l'instant de fin de chaque recharge ou décharge, ainsi, on peut obtenir toutes les $\Delta Q_i$ et $\Delta SOC_i$ pendant l'intervalle complet de chaque recharge et décharge.

5. Un procédé de diagnostic pour distinguer les défauts de micro-court-circuit et de petite capacité d'une batterie selon la revendication 1, **caractérisé en ce que**, pour la méthode d'estimation de la capacité décrite dans la S2, la formule de calcul de la capacité de la cellule i est la suivante :

$$C_i = \frac{\int_{t_0}^{t_j} I(t)dt}{\Delta SOC_i}$$

$$\Delta Q_i(t_j) = C_i \Delta SOC_i + b$$

Où $C_i$ représente la capacité de la cellule i, qui est inconnue, cependant, en définissant ($\Delta SOC_i$, $\Delta Q_i$) comme point caractéristique, la relation linéaire entre $\Delta Q_i$ et $SOC_i$ peut être reflétée sous la forme d'un nuage de points formé par plusieurs points caractéristiques, et la capacité C, d'une cellule i peut être obtenue sur la base de la méthode de régression linéaire.

Calculating a mean state of charge (SOC$_{mean}$) of a battery pack

Calculating a difference (dSOC) between the state of charge of a cell and the mean state of charge (SOC$_{mean}$) of the battery pack

S1

Calculating the state of charge (SOC) of the cell

Calculating transferred charge quantity and SOC variable quantity at every moment

S2

Utilizing a least square method to estimate the capacity of the cell under charge and discharge conditions

First determining a normal cell

Whether the capacity under the charge and discharge conditions is satisfied? Whether the estimated value is less than that of the normal cell?

Yes

No

S3

Small-capacity cell

Whether the estimated value of the capacity under the discharge condition is less than that of the normal cell, and the estimated value of the capacity under the charge condition is greater than that of the normal cell?

Yes

No

Micro-short-circuit cell

Quit

FIG. 1

Mean battery model

Difference battery model

FIG. 2

FIG. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **ZHENG YUEJIU et al.** *Micro-Short-Circuit Cell Fault Identification Method for Lithium-Ion Battery Packs Based on Mutual Information*

- **GAO WENKAI et al.** *Micro-Short-Circuit Diagnosis for Series-Connected Lithium-Ion Battery Packs Using Mean-Difference Model*